Europäisches Patentamt

European Patent Office

Office européen des brevets

(19)

(11) **EP 0 752 706 A1**

(12) **EUROPÄISCHE PATENTANMELDUNG**

(43) Veröffentlichungstag:
08.01.1997 Patentblatt 1997/02

(51) Int. Cl.⁶: **G11C 29/00**

(21) Anmeldenummer: 96110398.3

(22) Anmeldetag: 27.06.1996

(84) Benannte Vertragsstaaten:
**AT DE FR GB IE IT NL**

(30) Priorität: **07.07.1995 DE 19524874**

(71) Anmelder: **SIEMENS AKTIENGESELLSCHAFT**
**80333 München (DE)**

(72) Erfinder:
- **Murphy, Brian**
  **84347 Pfarrkirchen (DE)**
- **Walter, Rudolph**
  **Plano, Texas (US)**

(54) **Verfahren zum Versetzen einer integrierten Schaltung von einer ersten in eine zweite Betriebsart**

(57)    Verfahren zum Versetzen einer integrierten Schaltung von einer ersten in eine zweite Betriebsart. Es ist für die zweite Betriebsart ein Gesamtcode (GC) vorgesehen, der sich aus mehreren Einzelcodes (EC1, EC2) zusammensetzt. Jeder Einzelcode (EC1, EC2) besteht aus wenigstens zwei Signalen ($\overline{WE}$, $\overline{RAS}$, $\overline{CAS}$, A, D), die an Anschlüssen der integrierten Schaltung anlegbar sind. Nur wenn während des Betriebes der integrierten Schaltung in der ersten Betriebsart alle Einzelcodes (EC1, EC2) in der richtigen Reihenfolge an den entsprechenden Anschlüssen anliegen, wird die integrierte Schaltung in die zweite Betriebsart versetzt. Die erste Betriebsart kann bei einer integrierten Speicherschaltung beispielsweise eine Normalbetriebsart und die zweite Betriebsart eine Testbestriebsart sein. Durch Wahl eines komplexeren Gesamtcodes (GC) kann die Wahrscheinlichkeit eines zufälligen Wechsels in die zweite Betriebsart immer weiter reduziert werden.

FIG 2

**Beschreibung**

Die Erfindung betrifft ein Verfahren zum Versetzen einer integrierten Schaltung von einer ersten in eine zweite Betriebsart.

Der "JEDEC-Standard for Test-Mode Entry in Dynamic Memories" standardisiert für dynamische integrierte Speicherschaltungen (DRAMs) ein Verfahren zum Versetzen dieser von einer Normalbetriebsart in eine Testbetriebsart. Der JEDEC-Standard sieht vor, den Betriebsartwechsel durch eine Folge von Steuersignalen, einen sogenannten "$\overline{C\,AS}$ und $\overline{W\,E}$ before $\overline{R\,AS}$"-Zyklus einzuleiten, der als "Test Mode Entry" bezeichnet wird. ($\overline{C\,AS}$ = Column Address Strobe, $\overline{R\,AS}$ = Row Address Strobe, $\overline{W\,E}$ = Write Enable). Es handelt sich hierbei um eine in der Normalbetriebsart nicht vorgesehene zeitliche Reihenfolge der fallenden Flanken der genannten Steuersignale, und zwar kommt die fallende Flanke von $\overline{R\,AS}$ nach den fallenden Flanken von $\overline{C\,AS}$ und $\overline{W\,E}$, was in der Normalbetriebsart nicht der Fall ist.

Der JEDEC-Standard sieht weiterhin vor, eine auf den "$\overline{C\,AS}$ und $\overline{W\,E}$ before $\overline{R\,AS}$"-Zyklus folgende, an Adreßanschlüssen der integrierten Speicherschaltung anliegende Adresse zur weiteren Identifizierung der Testbetriebsart zu verwenden. Auf diese Weise ist es auch möglich, durch die Kombination des "$\overline{C\,AS}$ und $\overline{W\,E}$ before $\overline{R\,AS}$"-Zyklus mit unterschiedlichen Adressen unterschiedliche Testbetriebsarten zu definieren. Von besonderem Interesse sind hierbei Testbetriebsarten, die nur vom Hersteller der integrierten Speicherschaltung, nicht jedoch vom Anwender durchzuführen sind, beispielsweise auf Wafer-Ebene. In derartigen Testbetriebsarten ist ein Betrieb der integrierten Speicherschaltung wie in der Normalbetriebsart in der Regel nicht möglich. Es kann nämlich beispielsweise vorgesehen sein, in der Testbetriebsart bestimmte Teile der integrierten Speicherschaltung von anderen Teilen unabhängig zu betreiben Daher ist es wünschenswert, daß ein Betriebsartwechsel nicht zufällig beim Betrieb der Speicherschaltung durch den Anwender eintreten kann.

In der Praxis kommt es trotz des JEDEC-Standards zu Problemen:

Zum einen halten sich nicht alle Hersteller in gleicher Weise an diesen Standard. Zwar wird zum Großteil ein "$\overline{C\,AS}$ und $\overline{W\,E}$ before $\overline{R\,AS}$"-Zyklus verwendet, nicht jedoch die im Standard vorgesehenen Adressen, sondern je nach Hersteller davon abweichende. Oft sind vom Hersteller auch überhaupt keine zusätzlichen codierten Adressen vorgesehen, so daß ein Wechsel der Betriebsart allein durch einen "$\overline{C\,AS}$ und $\overline{W\,E}$ before $\overline{R\,AS}$"-Zyklus ausgelöst wird. Es ist also möglich, daß bei gleichartigen integrierten Schaltungen von unterschiedlichen Herstellern beim Anlegen derselben Signalkombination ein Wechsel in unterschiedliche Testbetriebsarten erfolgt. Es kann auch vorkommen, daß eine bestimmte Signalkombination bei integrierten Schaltungen eines Herstellers keinen, bei denen eines anderen Herstellers jedoch einen Betriebsartwechsel zur Folge hat. Dies ist insbesondere für Anwender von Nachteil, die in von ihnen benutzten Systemen nicht nur integrierten Schaltungen eines Herstellers verwenden möchten, sondern eine "Second Source" einbeziehen möchten.

Zum anderen kann es, beispielsweise beim Einschalten der integrierten Speicherschaltung oder durch Noise, dazu kommen, daß ein "$\overline{C\,AS}$ und $\overline{W\,E}$ before $\overline{R\,AS}$"-Zyklus mit der für das Versetzen in die Testbetriebsart notwendigen Adresse nur zufällig an den entsprechenden Anschlüssen der integrierten Speicherschaltung anliegt. Da sich durch einen derartigen unbeabsichtigten Wechsel das Betriebsverhalten der integrierten Schaltung in der Regel beträchtlich und unvorhersehbar ändert kann dies für einen Anwender der integrierten Schaltung von großem Nachteil sein. Dies ist umso mehr der Fall, als der Wechsel oft unbemerkt erfolgt.

Der Erfindung liegt die Aufgabe zugrunde, ein Verfahren zum Versetzen einer integrierten Schaltung von einer ersten in eine zweite Betriebsart zu schaffen, bei dem die Wahrscheinlichkeit eines unbeabsichtigten Wechsels der Betriebsart wesentlich geringer als beim Stand der Technik ist.

Diese Aufgabe wird mit einem Verfahren gemäß Anspruch 1 gelöst.

Weiterbildungen der Erfindung sind in den Unteransprüchen gekennzeichnet.

Die Erfindung unterscheidet sich vom geschilderten JEDEC-Standard insbesondere dadurch, daß mehrere Einzelcodes vorgesehen sind, die einen Gesamtcode bilden. Die Einzelcodes liegen nacheinander an entsprechenden Anschlüssen der integrierten Schaltung an und für die Signale jedes Einzelcodes findet eine separate Überprüfung auf Übereinstiummung mit zuvor festgelegten Signalverläufen statt. Beim JEDEC-Standard gibt es nur eine einmalige Überprüfung lediglich eines Codes.

Die Erfindung wird im folgenden anhand der Zeichnung näher erläutert. Es zeigen:

Figur 1      ein grobes Ablaufdiagramm der Verfahrensschritte,

Figur 2      eine erfindungsgemäße Codierung am Beispiel eines DRAMs.

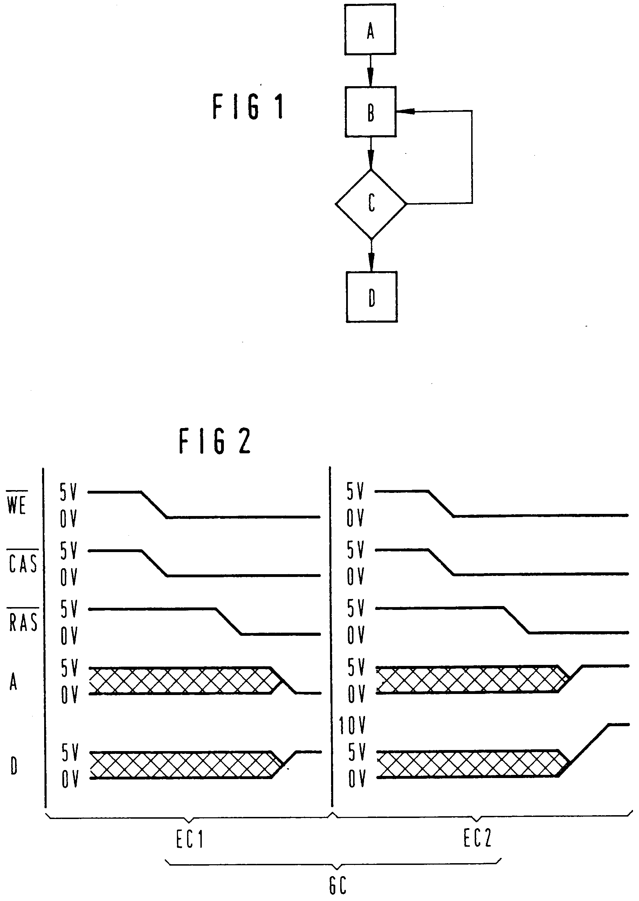

Figur 1: Das erfindungsgemäße Verfahren sieht vor, in einem ersten Schritt A zunächst einen mehrstufigen Gesamtcode GC zur Kennzeichnung einer zweiten Betriebsart festzulegen. Ein solcher Gesamtcode GC setzt sich aus mehreren Einzelcodes EC1, EC2 zusammen, deren Reihenfolge ebenfalls festgelegt wird. Jeder der Einzelcodes EC1, EC2 weist wenigstens zwei Signale $\overline{W\,E}$, $\overline{R\,AS}$, $\overline{C\,AS}$, A, D auf, die gleichzeitig an je einem Anschluß der integrierten Schaltung anlegbar sind. Sie weisen Signalverläufe auf, die ebenfalls festgelegt werden, und werden weiter unten anhand der Figur 2 beschrieben.

In einem zweiten Schritt B wird die integrierten Schaltung in einer ersten Betriebsart betrieben. Während des Betriebs in der ersten Betriebsart wird in einem dritten Schritt C überprüft, ob alle Einzelcodes EC1, EC2 des Gesamtcodes GC in der festgelegten Reihenfolge an den entsprechenden Anschlüssen anliegen. Wenn dies nicht der Fall ist, bleibt die integrierte Schaltung in der ersten Betriebsart. Trifft es jedoch zu, wird sie in einem vierten Schritt D in die zweite Betriebsart versetzt.

Die Verifizierung des Gesamtcodes GC (dritter Schritt C) erfolgt dabei in folgender Weise: Während des Betriebs der integrierten Schaltung in der ersten Betriebsart wird überprüft, ob die Signale $\overline{WE}$, $\overline{RAS}$, $\overline{CAS}$, A, D, die denjenigen Einzelcode EC1 des Gesamtcodes GC bilden, welcher in der festen Reihenfolge an erster Stelle festgelegt wurde, mit den festgelegten Signalverläufen an den entsprechenden Anschlüssen anliegen. Ist dies der Fall, wird geprüft, ob als nächstes der zweite Einzelcode EC2 anliegt und so fort. Ist nur einer der Einzelcodes EC1, EC2 falsch, bleibt die integrierte Schaltung in der ersten Betriebsart und die Anschlüsse werden erneut auf den ersten Einzelcode EC1 hin überprüft, d.h. es wird der dritte Schritt C fortwährend wiederholt. Liegen alle Einzelcodes EC1, EC2 des Gesamtcodes GC in der festen Reihenfolge an, erfolgt ein Wechsel der Betriebsart (vierter Schritt D).

Die Überprüfung auf Anliegen der die Einzelcodes EC1, EC2 bildenden Signale $\overline{WE}$, $\overline{RAS}$, $\overline{CAS}$, A, D mit den festgelegten Signalverläufen kann zu im vorhinein festlegbaren Zeitpunkten oder (z.B. im Falle der Überprüfung der zeitlichen Reihenfolge von Signalflanken) innerhalb von im vorhinein festlegbaren Zeiträumen stattfinden. Die Überprüfung kann beispielsweise in regelmäßigen zeitlichen Intervallen erfolgen. Diese Intervalle können mit der Zyklusdauer eines Steuersignals $\overline{WE}$, $\overline{RAS}$, $\overline{CAS}$ der integrierten Schaltung übereinstimmen. Es ist aber auch möglich, daß fortwährend überprüft wird, ob die Einzelcodes EC1, EC2 an den Anschlüssen anliegen.

Vorrichtungen zur Überprüfung der Signalverläufe von an Anschlüssen einer integrierten Schaltung anliegenden Signalen auf Übereinstimmung mit zuvor festgelegten Signalverläufen sowie zur anschließenden Aktivierung einer zweiten Betriebsart sind dem Fachmann bekannt und werden daher hier nicht näher erläutert.

Anhand Figur 2 wird nun bezüglich des Beispiels einer dynamischen Speicherschaltung (DRAM) das Festlegen des Gesamtcodes GC erläutert. Die erste Betriebsart soll hierbei eine Normalbetriebsart und die zweite Beetriebsart eine Testbetriebsart sein. Gezeigt ist ein möglicher Gesamtcode GC für die Codierung der zweiten Betriebsart. Der Gesamtcode GC setzt sich bei diesem Ausführungsbeispiel aus zwei Einzelcodes EC1, EC2 zusammen. Dabei soll der erste Einzelcode EC1 zeitlich vor dem zweiten Einzelcode EC2 an den entsprechenden Anschlüssen anliegen. Für die Codierung der Einzelcodes EC1, EC2 werden drei Steuersignale $\overline{WE}$, $\overline{CAS}$, $\overline{RAS}$, ein Adreßsignal A sowie ein Datensignal D verwendet, die an Anschlüssen der integrierten Speicherschaltung anlegbar sind.

Bei den Anschlüssen, an die die Signale $\overline{WE}$, $\overline{RAS}$, $\overline{CAS}$, A, D anlegbar sind, handelt es sich im Falle einer gehäuselosen integrierten Schaltung um interne Anschlüsse (Anschlußpads). Bei integrierten Schaltungen mit Gehäuse sind es externe Anschlüsse (Anschlußpins).

Die Steuersignale $\overline{WE}$, $\overline{RAS}$, $\overline{CAS}$ können beispielsweise ein Write Enable- $\overline{WE}$, ein Column Address Strobe- $\overline{CAS}$ und ein Row Address Strobe-Signal $\overline{RAS}$ sein.

Bei den Signalverläufen beider Einzelcodes EC1, EC2 ist für die Steuersignale $\overline{WE}$, $\overline{RAS}$, $\overline{CAS}$ ein "$\overline{CAS}$ und $\overline{WE}$ before $\overline{RAS}$"-Zyklus vorgesehen. Außerdem hat beim ersten Einzelcode EC1 das Adreßsignal A einen Pegel von 0 V und das Datensignal D einen Pegel von 1 V. Beim zweiten Einzelcode EC2 hat das Adreßsignal A einen Pegel von 1 V und das Adreßsignal D einen Pegel von 10 V.

Bei diesem Ausführungsbeispiel weisen durch den "$\overline{CAS}$ und $\overline{WE}$ before $\overline{RAS}$"-Zyklus die negativen Flanken der Steuersignale $\overline{WE}$, $\overline{CAS}$ und $\overline{RAS}$ einen gegenüber der ersten Betriebsart unterschiedlichen zeitlichen Verlauf auf. Außerdem wird angenommen, daß die Spezifikation für die zulässigen Werte des Datensignals D am entsprechenden Anschluß in der ersten Betriebsart nur einen Spannungsbereich von 0 bis 5 V zuläßt, so daß der hohe Spannungspegel von 10 V beim zweiten Einzelcode EC2 außerhalb dieser Spezifikation liegt. Sowohl ein "$\overline{CAS}$ und $\overline{WE}$ before $\overline{RAS}$"-Zyklus als auch ein Spannungswert außerhalb der Spezifikation können in der ersten Betriebsart nur durch relativ seltene Fehlfunktionen ausgelöst werden, so daß sie sich besonders gut für eine Codierung eignen.

Die Überprüfung der Steuersignale $\overline{WE}$, $\overline{CAS}$ und $\overline{RAS}$ bezüglich ihrer Flanken muß in einem Zeitintervall stattfinden, während die Überprüfung des Adreßsignals A und des Datensignals D zu Zeitpunkten erfolgen kann. Das Zeitintervall bzw. die Zeitpunkte können im vorhinein festlegbar sein. Es kann jedoch auch eine fortwährende Überprüfung auf Anliegen der Einzelcodes EC1, EC2 stattfinden. Bei dynamischen Speichern empfiehlt sich insbesondere die Überprüfung auf das Anliegen je eines der Einzelcodes EC1, EC2 pro Speicherzyklus. Bei diesem Ausführungsbeispiel erfolgt zunächst eine Überprüfung der zeitlichen Reihenfolge der negativen Flanken der Steuersignale $\overline{WE}$, $\overline{RAS}$, $\overline{CAS}$ und danach eine Überprüfung des Adreßsignals A und des Datensignals D.

Bei anderen Ausführungsformen der Erfindung können zur Codierung der Einzelcodes EC1, EC2 auch lediglich zwei der Steuersignale $\overline{WE}$, $\overline{CAS}$, $\overline{RAS}$ vorgesehen werden, deren zeitlicher Signalverlauf von demjenigen in der ersten Betriebsart abweicht. Es können auch mehrere Adreßsignale A und/oder Datensignale D sowie mehr als zwei Einzelcodes EC1, EC2 für die Codierung des Gesamtcodes GC vorgesehen werden.

Je mehr Signale $\overline{WE}$, $\overline{RAS}$, $\overline{CAS}$, A, D zur Codierung der Einzelcodes EC1, EC2 und je mehr Einzelcodes EC1, EC2 zur Bildung des Gesamtcodes GC zur Verfügung stehen, desto komplexer ist die Codierung und desto unwahrscheinlicher wird ein zufälliger, ungewollter Wechsel in die zweite Betriebsart. Die Wahrscheinlichkeit, durch Anlegen von Signalen zufällig einen Betriebsartwechsel auszulösen, errechnet sich bei x Adreß- und/oder Datensignalen A, D und y Einzelcodes EC1, EC2 nach der Formel

$$W = \left(\frac{1}{2^x}\right)^y = \frac{1}{2^{x \cdot y}}.$$

Weisen die Einzelcodes EC1, EC2 neben den Adreß- und/oder Datensignalen A, D noch die Steuersignale $\overline{WE}$, $\overline{RAS}$, $\overline{CAS}$ auf, müssen zusätzlich auch diese mit den entsprechenden Flankenwechseln richtig anliegen, wodurch ein zufälliger Wechsel noch unwahrscheinlicher wird.

Es ist insbesondere günstig, wenn sich jeder Einzelcode EC1, EC2 vom in der festen Reihenfolge vorausgegangenen unterscheidet, wie im in Figur 2 dargestellten Ausführungsbeispiel.

Für eine Implementierung des erfindungsgemäßen Verfahrens ist es günstig, für alle Einzelcodes EC1, EC2 die gleiche Anzahl von Signalen und die gleichen Anschlüsse der integrierten Schaltung S zu verwenden.

Mit unterschiedlichen Gesamtcodes GC ist es möglich, sofern eine ausreichende Anzahl von Einzelcodes EC1, EC2 und/oder von Signalen $\overline{WE}$, $\overline{RAS}$, $\overline{CAS}$, A, D zur Verfügung steht, beliebig viele verschiedene Betriebsarten zu Codieren, in die ein Versetzen von der ersten Betriebsart durchgeführt werden kann. Während des Betriebs der integrierten Schaltung in der ersten Betriebsart muß dann eine Überprüfung der an den entsprechenden Anschlüssen anliegenden Signale $\overline{WE}$, $\overline{RAS}$, $\overline{CAS}$, A, D hinsichtlich jedes der Gesamtcodes GC erfolgen.

## Patentansprüche

1. Verfahren zum Betrieb einer integrierten Schaltung mit Anschlüssen zum Anlegen je eines Signales ($\overline{WE}$, $\overline{RAS}$, $\overline{CAS}$, A, D),

   - die integrierte Schaltung wird in einer ersten Betriebsart betrieben,
   - die integrierte Schaltung wird in eine zweite Betriebsart versetzt, indem ein mehrstufiger Gesamtcode (GC) an die Anschlüsse angelegt wird, der sich aus mehreren zeitlich aufeinander folgenden Einzelcodes (EC1, EC2) zusammensetzt, von denen jeder wenigstens zwei der Signale ($\overline{WE}$, $\overline{RAS}$, $\overline{CAS}$, A, D) mit jeweils definierten Signalverläufen aufweist.

2. Verfahren nach Anspruch 1,

   **dadurch gekennzeichnet,**
   daß die erste Betriebsart eine Normalbetriebsart und die zweite Betriebsart eine Testbetriebsart ist.

3. Verfahren nach einem der vorstehenden Ansprüche,
   **dadurch gekennzeichnet,**
   daß eines (D) der Signale ($\overline{WE}$, $\overline{RAS}$, $\overline{CAS}$, A, D) einen Potentialpegel aufweist, der außerhalb der Spezifikation für die zulässigen Potentialwerte am entsprechenden Anschluß in der ersten Betriebsart liegt.

4. Verfahren nach einem der vorstehenden Ansprüche,
   **dadurch gekennzeichnet,**
   daß wenigstens zwei der Signale ($\overline{WE}$, $\overline{RAS}$, $\overline{CAS}$, A, D) Steuersignale ($\overline{WE}$, $\overline{RAS}$, $\overline{CAS}$) der integrierten Schaltung sind
   und daß die zeitliche Reihenfolge von Flanken dieser Steuersignale ($\overline{WE}$, $\overline{RAS}$, $\overline{CAS}$) gegenüber derjenigen, die in der ersten Betriebsart vorgesehen ist, verändert ist.

5. Verfahren nach einem der vorstehenden Ansprüche,
   **dadurch gekennzeichnet,**
   daß wenigstens eines der Signale ($\overline{WE}$, $\overline{RAS}$, $\overline{CAS}$, A, D) ein Adreßsignal (A) und/oder ein Datensignal (D) der integrierten Schaltung ist.

6. Integrierte Schaltung mit Anschlüssen zum Anlegen je eines Signales ($\overline{WE}$, $\overline{RAS}$, $\overline{CAS}$, A, D),
   die von einer ersten in eine zweite Betriebsart versetzbar ist mittels Anlegen eines mehrstufigen Gesamtcodes (GC) an die Anschlüsse, der sich aus mehreren zeitlich aufeinander folgenden Einzelcodes (EC1, EC2) zusammensetzt, von denen jeder wenigstens zwei der Signale ($\overline{WE}$, $\overline{RAS}$, $\overline{CAS}$, A, D) mit jeweils definierten Signalverläufen aufweist.

7. Integrierte Schaltung nach Anspruch 6,
   die eine integrierte Speicherschaltung ist.

FIG 1

FIG 2

Europäisches
Patentamt

EUROPÄISCHER RECHERCHENBERICHT

Nummer der Anmeldung

EP 96 11 0398

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-5 245 577 (DUESMAN ET AL.) <br> * Zusammenfassung; Ansprüche 1-4,8-14; Abbildungen 2,3 * <br> --- | 1-4,6,7 | G11C29/00 |
| A | US-A-5 072 138 (SLEMMER ET AL.) <br> * Spalte 23, Zeile 53 - Spalte 28, Zeile 52 * <br> * Zusammenfassung; Ansprüche 1-8; Abbildungen 7,8 * <br> --- | 1-7 | |
| A | DE-A-43 36 884 (MITSUBISHI DENKI K.K.) <br> * Zusammenfassung; Abbildungen 4-7,11,12; Beispiele 1-10 * <br> --- | 1-7 | |
| P,A | US-A-5 452 253 (CHOI) <br> * Zusammenfassung; Ansprüche 1-3; Abbildungen 2,3,6,7 * <br> ----- | 1-7 | |

RECHERCHIERTE SACHGEBIETE (Int.Cl.6)

G11C
G06F

Der vorliegende Recherchenbericht wurde für alle Patentansprüche erstellt

| Recherchenort | Abschlußdatum der Recherche | Prüfer |
|---|---|---|
| DEN HAAG | 8.August 1996 | Sarasua Garcia, L |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes
   Dokument

EPO FORM 1503 03.82 (P04C03)